# FASCICULE DE BREVET EUROPEEN

(11) **EP 0 501 869 B1**
(45) Date de publication et mention de la délivrance du brevet: **09.11.1994**
(21) Numéro de dépôt: 92400479.9
(22) Date de dépôt: 25.02.1992
(51) Int. Cl.: H05K 7/20

(54) **Enceinte de réception de composants électroniques, embarquée sur un missile**
Gehäuse zur Aufnahme von an Bord einer Rakete mitgenommen elektronischen Baugruppen
Casing for electronic components on board a missile

(30) Priorité: 27.02.1991 FR 9102335
(43) Date de publication de la demande: 02.09.1992
(73) Titulaire: SAT (Société Anonyme de Télécommunications), 75116 Paris (FR)
(72) Inventeur: Sabah, Jacques, F-94300 Vincennes (FR)
(74) Mandataire: Bloch, Gérard

(56) Documents cités:
- WO-A-87/06091
- US-A- 3 904 933
- ELECTRONICS vol. 50, no. 17, Août 1977, NEW YORK,US pages 50 - 52; 'RIGID ASSEMBLY TAKES CANNON-LAUNCH G'

## Description

L'invention concerne une enceinte de réception de composants électroniques embarquée sur un missile destiné d'abord à être fixé à un aéronef porteur et suivre un vol porté puis, après mise à feu, à suivre un vol libre.

Pendant le vol porté, l'extérieur se comporte comme une source froide et les calories dissipées par les composants peuvent être évacuées par l'enceinte. Par contre, en vol libre, après la mise à feu, l'extérieur proche du missile se comporte comme une source chaude et non seulement les calories dissipées par les composants ne peuvent plus être évacuées mais ces composants sont soumis à un apport d'énergie thermique préjudiciable au maintien de leurs performances.

La présente invention vise à pallier cet inconvénient et à isoler l'enceinte de l'extérieur en vol libre.

A cet effet, la présente invention concerne une enceinte du type mentionné ci-dessus, caractérisée par le fait qu'elle est disposée à l'intérieur d'une enveloppe extérieure et qu'il est prévu des moyens sensibles à l'accélération agencés pour, en deçà d'une accélération déterminée, former un pont thermique entre l'enceinte et l'enveloppe et, au-delà de l'accélération déterminée, rompre ce pont thermique et isoler l'enceinte de l'extérieur.

Ainsi, l'accélération au-delà de laquelle le pont thermique est rompu correspondant à celle que subissent le missile et donc l'enceinte lors de la mise à feu, l'enceinte et l'enveloppe extérieure sont thermiquement reliées en vol porté et les calories des composants peuvent être évacuées, alors qu'en vol libre, au cours duquel l'extérieur proche se comporte comme une source chaude, l'enceinte est isolée de l'extérieur.

L'invention tire son originalité de la prise en compte de la concomitance de l'inversion du comportement de l'environnement extérieur du missile et de la soudaine accélération qu'il subit au moment de sa mise à feu.

Dans une forme de réalisation préférée, lesdits moyens sensibles à l'accélération comportent des secteurs en forme de coin chacun monté mobile sur au moins une rampe inclinée de l'enceinte, entre une position avant de pontage thermique et une position arrière d'isolation.

Avantageusement, l'enceinte comporte des moyens de rappel des secteurs en position de pontage et des moyens de maintien de ces secteurs en position d'isolation, les moyens de rappel étant de préférence des moyens de rappel élastique.

Avantageusement encore, les secteurs sont en matériau métallique et les moyens de rappel et les moyens de maintien comportent des aimants.

Avantageusement toujours, les moyens de rappel comprennent au moins un piston à ressort duquel est solidaire un aimant.

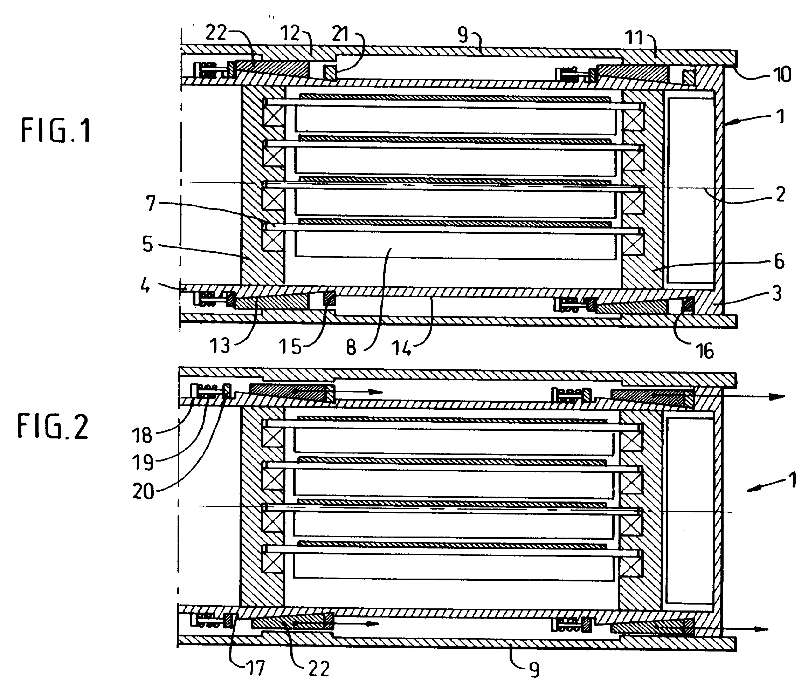

L'invention sera mieux comprise à l'aide de la description suivante de la forme de réalisation préférée de l'enceinte de l'invention, en référence au dessin annexé, sur lequel
- la figure 1 est une vue en coupe longitudinale de l'enceinte, en position de vol porté, et
- la figure 2 est une vue en coupe longitudinale de l'enceinte, en vol libre.

L'enceinte 1 représentée sur les figures a une forme générale cylindrique d'axe 2. Toutefois, l'invention s'appliquerait tout aussi bien à des enceintes de forme générale parallélépipédique.

L'enceinte 1 comporte une base arrière 3 prolongée, vers l'avant, par une jupe 4 à l'intérieur de laquelle sont disposées des glissières thermiques 5, 6 de réception de cartes électroniques 7 sur lesquelles sont montés des composants 8, dont des composants actifs dissipant, en fonctionnement, relativement beaucoup d'énergie.

L'enceinte 1 est coiffée d'une enveloppe extérieure 9 en appui contre la paroi latérale de la base arrière 3 par une surface interne 10 de diamètre réduit d'un bourrelet arrière 11 qui se prolonge vers l'avant au-delà de la base arrière 3 de l'enceinte.

L'enveloppe 9 possède à l'avant un autre bourrelet 12 de même diamètre interne que le bourrelet arrière 11.

En regard des bourrelets 11, 12 de l'enveloppe 9, la jupe 4 de l'enceinte présente des rampes externes 13 inclinées vers l'arrière de l'extérieur vers l'intérieur et raccordées à l'arrière, à l'avant de l'enceinte, à la surface latérale 14 de la jupe 4 par un épaulement 15 et, à l'arrière de l'enceinte, à la base arrière 3 par un épaulement 16. A l'avant, les rampes 13 sont raccordées à la jupe 4 par un autre épaulement 17 par conséquent plus profond que les épaulements 15, 16.

Un aimant 21 est disposé dans chaque épaulement 15, 16, entre l'enceinte 1 et l'enveloppe 9, de dimension appropriée pour ne pas constituer entre elles un pont thermique. A l'avant des épaulements 17, sur la jupe 4, sont fixés des pistons 18 à ressort 19 auquel est fixé un aimant 20 légèrement en avant de l'épaulement 17.

Entre chaque bourrelet 11, 12 de l'enveloppe 9 et chaque rampe inclinée 13 de la jupe 4 de l'enceinte 1 est monté, pour coulisser sur la rampe 13, un secteur métallique de pontage et d'isolation 22 à section longitudinale en forme de coin complémentaire de celle de la rampe, d'épaisseur arrière inférieure à la distance entre le bourrelet et le fond de l'épaulement arrière de raccordement de la rampe mais supérieure à son épaisseur avant. Dans l'exemple considéré, le coulissement des secteurs 22 sur les rampes 13 est assuré par l'intermédiaire de glissières droites ici à section en forme de T, fixées sur les rampes 13, les secteurs 22 étant conformés de façon complémentaire dans leur section transversale.

Dans l'exemple considéré toujours, les secteurs 22 sont des secteurs annulaires s'étendant angulairement sur deux rampes inclinées 13.

Pendant un vol porté, en l'absence d'accélération notable, les secteurs 22 sont rappelés vers l'avant par les pistons 18 et leurs aimants 20 qui les attirent. Dans cette position avant, les secteurs 22 forment un pont thermique entre l'enceinte 1 et son enveloppe extérieure 9. Les calories dissipées par les composants 8 peuvent être évacuées par un chemin traversant les glissières 6, la jupe 4 et l'enveloppe 9.

On remarquera que les ressorts 19 des pistons 18 permettent, en vol porté, d'absorber des accélérations du porteur, inférieures à l'accélération de mise à feu du missile, les secteurs 22 restant plaqués contre les bourrelets 11, 12 de l'enveloppe 9 sous l'action des aimants 20 dont la force d'attraction est supérieure à la force de recul engendrée par ces accélérations du porteur.

La mise à feu du missile soumet l'enceinte 1 et l'enveloppe 9 à une accélération telle que les secteurs 22 échappent à l'attraction des aimants 20 et reculent vers l'arrière en coulissant sur les glissières des rampes 13 pour rompre le pontage thermique, ménager une lame d'air entre l'enceinte 1 et l'enveloppe 9 et finalement isoler celle-là de celle-ci. Ayant échappé à l'attraction des aimants avant 20, les secteurs 22, en fin de course, sont attirés par les aimants arrière 15 qui les maintiennent en position arrière d'isolation pendant le vol libre.

## Revendications

1. Enceinte (1) de réception de composants électroniques (8) embarquée sur un missile destiné d'abord à être fixé à un aéronef porteur et suivre un vol porté puis, après mise à feu, à suivre un vol libre, enceinte caractérisée par le fait qu'elle est disposée à l'intérieur d'une enveloppe extérieure (9) et qu'il est prévu des moyens (22) sensibles à l'accélération agencés pour, en deçà d'une accélération déterminée, former un pont thermique entre l'enceinte (1) et l'enveloppe (9) et, au-delà de l'accélération déterminée, rompre ce pont thermique et isoler l'enceinte (1) de l'extérieur.

2. Enceinte selon la revendication 1, dans laquelle lesdits moyens sensibles à l'accélération comportent des secteurs (22) en forme de coin chacun monté mobile sur au moins une rampe inclinée (13) de l'enceinte (1), entre une position avant de pontage thermique et une position arrière d'isolation.

3. Enceinte selon la revendication 2, dans laquelle sont prévus des moyens (18-20) de rappel des secteurs (22) en position de pontage.

4. Enceinte selon la revendication 3, dans laquelle les moyens de rappel (18-20) sont des moyens de rappel élastique agencés pour absorber des accélérations de l'aéronef porteur.

5. Enceinte selon l'une des revendications 2 à 4, dans laquelle sont prévus des moyens (21) de maintien des secteurs ( 22 ) en position d'isolation.

6. Enceinte selon la revendication 5, dans laquelle les moyens de maintien comportent des aimants (21).

7. Enceinte selon la revendication 4, dans laquelle les moyens de rappel comprennent au moins un piston (18) à ressort (19).

8. Enceinte selon l'une des revendications 3, 4 et 7, dans laquelle les moyens de rappel (18-20) comportent des aimants (20).

9. Enceinte selon la revendication 7, dans laquelle un aimant (20) est fixé au ressort (19) du piston (18).

## Patentansprüche

1. Gehäuse zur Aufnahme von elektronischen Baugruppen (8), die sich an Bord einer Rakete befinden, welche dazu bestimmt ist, zunächst an einem Träger-Luftfahrzeug befestigt zu sein und einen getragenen Flug zu verfolgen und nach dem Zünden einen freien Flug zu verfolgen, ein Gehäuse, dadurch gekennzeichnet, daß es im Innern einer Außenhülle (9) angeordnet ist und daß beschleunigungsempfindliche Mittel (22) vorgesehen sind, um diesseits einer bestimmten Beschleunigung eine Wärmebrücke zwischen dem Gehäuse (1) und der Hülle (9) zu bilden und jenseits der bestimmten Beschleunigung diese Wärmebrücke zu unterbrechen und das Gehäuse (1) vom Äußeren zu isolieren.

2. Gehäuse nach Anspruch 1, bei dem die beschleunigungsempfindlichen Mittel keilförmige Sektoren (22) umfassen, die jeweils beweglich auf mindestens einer schrägen Rampe (13) des Gehäuses (1) zwischen einer vorderen Position der Wärmebrückenbildung und einer hinteren Position der Isolation angebracht sind.

3. Gehäuse nach Anspruch 2, bei dem Mittel (18-20) zum Zurückholen der Sektoren (22) in die Position der Brückenbildung vorgesehen sind.

4. Gehäuse nach Anspruch 3, bei dem die Rückholmittel (18-20) elastische Rückholmittel sind, dafür vorgesehen, Beschleunigungen des Träger-Luftfahrzeugs zu absorbieren.

5. Gehäuse nach einem der Ansprüche 2 bis 4, bei dem Mittel (21) zum Festhalten der Sektoren (22) in der Position der Isolation vorgesehen sind.

6. Gehäuse nach Anspruch 5, bei dem die Haltemittel Magneten (21) umfassen.

7. Gehäuse nach Anspruch 4, bei dem die Rückholmittel mindestens einen Kolben (18) mit Feder (19) umfassen.

8. Gehäuse nach einem der Ansprüche 3, 4 und 7, bei dem die Rückholmittel (18-20) Magneten (20) umfassen.

9. Gehäuse nach Anspruch 7, bei dem ein Magnet (20) an der Feder (19) des Kolbens (18) befestigt ist.

## Claims

1. A container (1) for receiving electronic components (8), on board a missile intended first of all to be fixed to a carrying aircraft and to pursue a carried flight then, after firing, to pursue a free flight, a container characterised in that it is disposed inside an outer casing (9) and that it is provided with means (22) which are sensitive to acceleration and are arranged to form, below a predetermined acceleration, a thermal bridge between the container (1) and the casing (9) and, above the predetermined acceleration, to break this thermal bridge and to isolate the container (1) from the outside.

2. A container according to claim 1, in which the said means sensitive to acceleration comprise wedge-like sectors (22) each displaceably mounted on at least one inclined slope (13) of the container (1) between a front thermal bridging position and a rear isolation position.

3. A container according to claim 2, in which means (18-20) are provided for returning the sectors (22) to the bridging position.

4. A container according to claim 3, in which the return means (18-20) are elastic return means arranged to absorb accelerations of the carrier aircraft.

5. A container according to any of claims 2 to 4, in which means (21) are provided to maintain the sectors (22) in the isolation position.

6. A container according to claim 5, in which the maintaining means comprise magnets (21).

7. A container according to claim 4, in which the return means comprise at least one piston (18) with a spring (19).

8. A container according to any of claims 3, 4 and 7 in which the return means (18-20) comprise magnets (20).

9. A container according to claim 7, in which a magnet (20) is fixed to the spring (19) of the piston (18).
